# EUROPÄISCHE PATENTSCHRIFT

(11) **EP 1 222 738 B1**
(45) Veröffentlichungstag und Bekanntmachung des Hinweises auf die Patenterteilung: **14.05.2003**
(21) Anmeldenummer: 00982942.5
(22) Anmeldetag: 29.09.2000
(51) Int. Cl.: H03K 17/081

(54) **THYRISTORANORDNUNG MIT FREIWERDESCHUTZ**
THYRISTOR ARRANGEMENT WITH TURNOFF PROTECTION
ENSEMBLE THYRISTOR PRESENTANT UN SYSTEME D'INHIBITION DE DECLENCHEMENT

(30) Priorität: 30.09.1999 DE 19947036
(43) Veröffentlichungstag der Anmeldung: 17.07.2002
(73) Patentinhaber: SIEMENS AKTIENGESELLSCHAFT, 80333 München (DE)
(72) Erfinder: NIEDERNOSTHEIDE, Franz Josef, 48157 Münster (DE); RUFF, Martin, 91487 Vestenbergsgreuth (DE)
(86) Internationale Anmeldenummer: DE0003440
(87) Internationale Veröffentlichungsnummer: WO01026227

(56) Entgegenhaltungen:
- US-A- 3 590 346
- US-A- 4 195 306
- PATENT ABSTRACTS OF JAPAN vol. 005, no. 103 (E-064), 3. Juli 1981 (1981-07-03) & JP 56 046338 A (FUJI ELECTRIC CO LTD), 27. April 1981 (1981-04-27)
- PATENT ABSTRACTS OF JAPAN vol. 009, no. 248 (E-347), 4. Oktober 1985 (1985-10-04) & JP 60 097722 A (TOSHIBA KK), 31. Mai 1985 (1985-05-31)
- PATENT ABSTRACTS OF JAPAN vol. 005, no. 078 (E-058), 22. Mai 1981 (1981-05-22) & JP 56 025371 A (FUJI ELECTRIC CO LTD), 11. März 1981 (1981-03-11)

## Beschreibung

Die Erfindung betrifft gemäß dem Oberbegriff des Anspruchs 1 eine Thyristoranordnung mit
- einem Hauptthyristor, der eine Kathode und eine Anode aufweist,
- mindestens einem Hilfsthyristor, der eine Kathode und eine Anode aufweist,
- einer Widerstandseinrichtung, welche die Kathode des Hilfsthyristors und die Kathode des Hauptthyristors elektrisch miteinander verbindet und einen von null verschiedenen ohmschen Widerstand definiert,
- einer Anodenverbindung, welche die Anode des Hilfsthyristors und die Anode des Hauptthyristors elektrisch miteinander verbindet, und
- einer Zündeinrichtung zu einer Überkopfzündung des Hauptthyristors über den Hilfsthyristor und die Widerstandseinrichtung.

Eine Thyristoranordnung der genannten Art ist aus EP 0 301 761 B1 bekannt. Bei dieser bekannten Anordnung sind der Hauptthyristor mit seiner Kathode und Anode, der Hilfsthyristor mit seiner Kathode und Anode, die Widerstandseinrichtung, die Anodenverbindung in Form eines Kurzschlusses und die Zündeinrichtung auf einem gemeinsamen Körper aus Halbleitermaterial integriert.

Die Widerstandseinrichtung besteht aus einem ohmschen Widerstand. Dieser Widerstand dient zu einer elektrischen Strombegrenzung zwischen dem Hilfsthyristor und dem Hauptthyristor.

Die Zündeinrichtung ist eine elektrische Zündeinrichtung, und zwischen dieser Zündeinrichtung und dem Hilfsthyristor ist ebenfalls ein ohmscher Widerstand angeordnet, der ebenfalls zu einer Strombegrenzung dient.

Aus JP-A-59 141 269 geht ebenfalls eine Thyristoranordnung der eingangs genannten Art hervor, bei welcher der Hauptthyristor mit seiner Kathode und Anode, der Hilfsthyristor mit seiner Kathode und Anode, die Widerstandseinrichtung, die Anodenverbindung und die Zündeinrichtung auf einem gemeinsamen Körper aus Halbleitermaterial integriert sind.

Die Widerstandseinrichtung dieser bekannten Anordnung besteht aus einem einzelnen Widerstand und die Zündeinrichtung ist eine elektrische Zündeinrichtung.

Aufgrund der Tatsache, daß bei dieser bekannten Anordnung die Betriebsdauer des Hilfsthyristorteils länger ist als die des Hauptthyristorteils, kompensiert eine Vorwärtsspannung des Hilfsthyristors einen Spannungsabfall am Widerstand und es fließt auch im Hilfsthyristor ein Strom mit einer Stromdichte, die genauso groß oder größer als die im Hauptthyristor ist. Insbesondere ist aufgrund dieser Tatsache einerseits durch den Hilfsthyristor für ein Kippen gesorgt und wird andererseits ein Durchbruch infolge Stromkonzentration bei Kippen verhindert.

Aus H.-J. Schulze, M. Ruff, B. Baur, F. Pfirsch, H. Kazba, U. Kellner, P. Voss: "Light Triggered 8 kV Thyristor with a New Type of Integrated Breakover Diode", Proceedings of PCIM, Maui, 1996, S. 465 - 472, ist eine optische Zündeinrichtung zum Zünden eines auf einem Körper aus Halbleitermaterial integrierten Hauptthyristors mittels optischer Strahlung bekannt, wobei diese Zündeinrichtung und ein Hilfsthyristor auf diesem Körper aus Halbleitermaterial integriert ist.

Der Erfindung liegt die Aufgabe zugrunde, eine Thyristoranordnung bereitzustellen, die einen guten Freiwerdeschutz aufweist. Freiwerdeschutz bedeutet dabei generell einen Schutz dagegen, daß durch einen nicht vermeidbaren Spannungsanstieg während der Freiwerdezeit eines Thyristors der Thyristor unkontrolliert durchzünden und dadurch zerstört werden kann (siehe dazu DE 196 50 762 A1).

Diese Aufgabe wird durch eine Thyristoranordnung gelöst, welche die im Anspruch 1 angegebenen Merkmale aufweist.

Gemäß dieser Lösung ist wesentlich, daß die Widerstandseinrichtung einen zeitabhängigen ohmschen Widerstand derart definiert, daß dieser Widerstand während einer Einschaltphase des Hauptthyristors einen relativ großen Wert und während einer Stromführungsphase des Hauptthyristors einen relativ kleinen Wert aufweist.

Diese Lösung beruht auf folgenden Erkenntnissen: Der Hilfsthyristor soll auch während der Stromführungsphase des Hauptthyristors im leitenden Zustand bleiben. Um den Hilfsthyristor vor zu hohen Einschaltbelastungen zu schützen, ist ein Schutzwiderstand notwendig. Insbesondere wenn eine integrierte optische Zündeinrichtung diesen Hilfsthyristor zur kontrollierten Überkopfzündung des Hauptthyristors nutzt, ist der Schutzwiderstand notwendig. Ein zu hoher Schutzwiderstand, beispielsweise ein Widerstand mit einem Wert größer als 50 Ω verhindert aber, daß der Hilfythyristor auch während der Stromführungsphase des Hauptthyristors im leitenden Zustand bleibt und kann damit beispielsweise die Integration eines Freiwerdeschutzes verhindern.

Es kann gezeigt werden, daß der für einen Freiwerdeschutz brauchbare maximal zulässige Wert des Schutzwiderstandes typischerweise kleiner als 50 Ω sein muß.

Andererseits muß verhindert werden, daß der Hilfsthyristor durch einen zu hohen Strom während des Einschaltens des Hauptthyristors zerstört wird. Dies kann durch einen Schutzwiderstand eines Wertes größer als 50 Ω erreicht werden, wobei wiederum die Gefahr einer Verhinderung der Integration eines Freiwerdeschutzes besteht.

Wird der Widerstand durch eine Widerstandseinrichtung mit einem zeitabhängigen Widerstandswert ersetzt, die derart ausgebildet und/oder gesteuert ist, daß zu Beginn des Einschaltens der Thyristoranordnung der Strom des Hilfsthyristors effektiv begrenzt wird und gleichzeitig während der Stromführungsphase des Hauptthyristors der der Widerstandswert der Widerstandseinrichtung nur klein ist, so kann der Hilfsthyristor sowohl im Einschaltmoment geschützt werden als auch während der Stromführungsphase des Hauptthyristors im leitenden Zustand bleiben und damit die Integration eines Freiwerdeschutzes gelingen.

Die Widerstandseinrichtung kann beispielsweise ein ohmscher Widerstand sein, dessen Widerstandswert gesteuert veränderbar ist und der so gesteuert wird, daß der Widerstandswert während der Einschaltphase des Hauptthyristors relativ groß und während der Stromführungsphase des Hauptthyristors relativ klein ist.

Vorzugs und vorteilhafterweise ist die Widerstandseinrichtung so ausgebildet, daß der Widerstand von selbst vom relativ großen Wert auf den relativ kleinen Wert absinkt.

Eine bevorzugte und vorteilhafte Ausgestaltung einer solchen Widerstandseinrichtung weist einen ohmschen Widerstand eines im wesentlichen festen Wertes und eine Induktivität und/oder eine Kapazität auf. Die Kombination aus dem ohmschen Widerstand, der Induktivität und/oder der Kapazität ist lediglich so zu wählen, daß zu Beginn des Einschaltvorganges der Widerstandswert der Widerstandseinrichtung hoch ist, dann aber auf einen definierten kleineren Wert abnimmt

Bevorzugte und vorteilhafte Ausführungsformen einer solchen Ausgestaltung gehen aus den Ansprüchen 4 bis 7 hervor.

Bei einer vorteilhaften Ausgestaltung der erfindungsgemäßen Thyristoranordnung sind der Hauptthyristor mit seiner Kathode und Anode, der Hilfsthyristor mit seiner Kathode und Anode, die Widerstandseinrichtung, die Anodenverbindung und die Zündeinrichtung auf einem gemeinsamen Körper aus Halbleitermaterial integriert.

Bei dieser Ausgestaltung weist bevorzugter- und vorteilhafterweise die Widerstandseinrichtung eine integrierte Induktivität in Form einer auf dem Körper aus Halbleitermaterial ausgebildeten Spirale aus elektrisch leitendem Material auf.

Bei einer anderen vorteilhaften Ausgestaltung der erfindungsgemäßen Thyristoranordnung ist der Hauptthyristor mit seiner Kathode und Anode auf einem Körper aus Halbleitermaterial integriert, und ist der Hilfsthyristor mit seiner Kathode und Anode auf einem anderen Körper aus Halbleitermaterial integriert. Bei dieser Ausgestaltung, bei welcher der Hilfsthyristor extern vom Hauptthyristor ist, besteht der Vorteil der wesentlich größeren Freiheit bei der Gestaltung der Widerstandseinrichtung, insbesondere der eine Kombination aus ohmschem Widerstand, Induktivität und/oder Kapazität aufweisenden Widerstandseinrichtung. Vor allem besteht dabei eine wesentlich größere Freiheit bei der Gestaltung der Induktivität.

Bei der erfindungsgemäßen Thyristoranordnung ist die Zündeinrichtung vorzugs und vorteilhafterweise eine optische Zündeinrichtung, die auf einem Körper aus Halbleitermaterial des Hilfsthyristor integriert ist. Sind in diesem Fall der Hauptthyristor und der Hilfsthyristor auf einem gemeinsamen Körper aus Halbleitermaterial integriert, ist ein optisch zündbarer Hauptthyristor gegeben. Ist dagegen der Hilfsthyristor extern realisiert und über eine externe Widerstandseinrichtung mit dem Hauptthyristor verbunden, ist gewissermaßen ein elektrisch zündbarer Hauptthyristor gegeben.

Die Erfindung wird in der nachfolgenden Beschreibung anhand der Zeichnungen beispielhaft näher erläutert. Es zeigen:
- Figur 1: ein erstes Ausführungsbeispiel der erfindungsgemäßen Thyristoranordnung,
- Figur 2: eine Variante des ersten Ausführungsbeispiels,
- Figur 3: ein zweites Ausführungsbeispiel der erfindungsgemäßen Thyristoranordnung,
- Figur 4: eine Variante des zweiten Ausführungsbeispiels, und
- Figur 5: eine Draufsicht auf eine Induktivität in Form einer Spirale aus elektrisch leitendem Material.

Die Figuren sind schematisch und nicht maßstäblich.

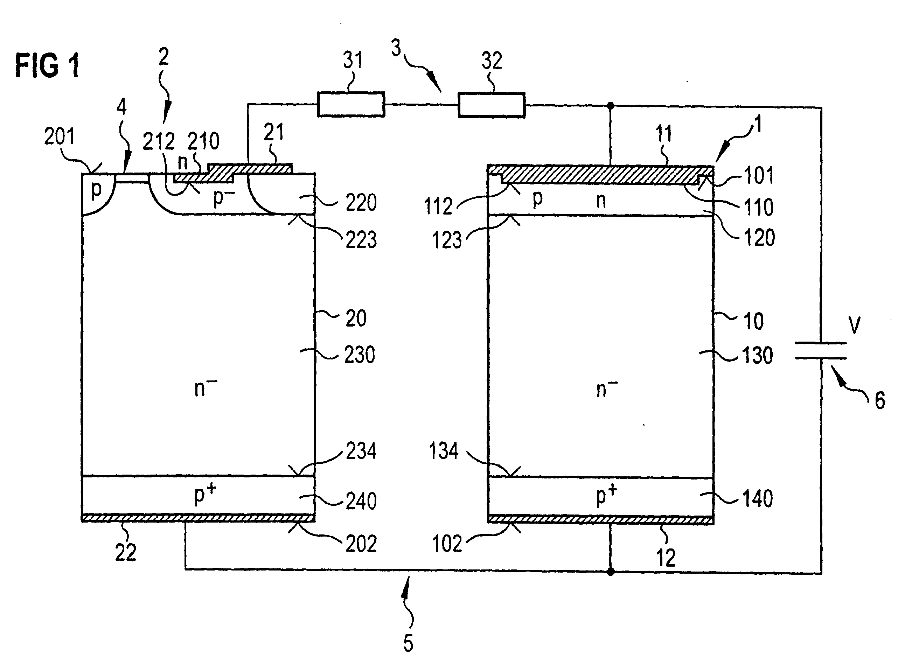

Bei den in den Figuren 1 bis 4 dargestellten Ausführungsbeispielen der erfindungsgemäßen Thyristoranordnung ist der Hauptthyristor generell mit 1, der Hilfsthyristor generell mit 2, die Widerstandseinrichtung generell mit 3 und die Zündeinrichtung generell mit 4 bezeichnet.

Der Hauptthyristor 1 weist einen Körper 10 aus unterschiedlich dotiertem Halbleitermaterial, beispielsweise Silizium, eine als Kathode dienende Elektrode 11 und eine als Anode dienende Elektrode 12 auf.

Die Kathode 11 und die Anode 12 sind auf voneinander abgekehrten Oberflächenbereichen 101 bzw. 102 des Körpers 10 ausgebildet.

Zwischen der Kathode 11 und der Anode 12 weist der Körper 10 einen als kathodenseitigen Emitter des Hauptthyristors 1 dienenden Bereich 110 aus n-dotiertem Halbleitermaterial auf, der im Bereich der Kathode 11 an den Oberflächenbereich 101 des Körpers 10 grenzt.

An den kathodenseitigen Emitter 110 grenzt ein als kathodenseitige Basis des Hauptthyristors 1 dienender Bereich 120 aus p-dotiertem Halbleitermaterial des Körpers 10 und bildet zusammen mit dem kathodenseitigen Emitter 110 einen np-Übergang 112.

An die kathodenseitige Basis 120 grenzt ein als anodenseitige Basis des Hauptthyristors 1 dienender Bereich 130 aus n⁻dotiertem Halbleitermaterial des Körpers 10 und bildet zusammen mit der kathodenseitigen Basis 120 einen pn-Übergang 123.

An die anodenseitige Basis 130 grenzt ein als anodenseitiger Emitter des Hauptthyristors 1 dienender Bereich 140 aus p⁺dotiertem Halbleitermaterial des Körpers 10. Der Bereich 140 bildet einerseits zusammen mit der anodenseitigen Basis 120 einen np-Übergang 134 und grenzt andererseits im Bereich der Anode 12 an den Oberflächenabschnitt 102 des Körpers 10

Bei den Ausführungsbeispielen nach den Figuren 1 bis 3 weist der Hilfsthyristor 2 beispielsweise einen vom Körper 10 des Hauptthyristors 1 getrennten anderen Körper 20 aus unterschiedlich dotiertem Halbleitermaterial, beispielsweise ebenfalls Silizium, eine als Kathode dienende Elektrode 21 und eine als Anode dienende Elektrode 22 auf.

Die Kathode 21 und die Anode 22 des Hilfsthyristors 2 sind auf voneinander abgekehrten Oberflächenbereichen 201 bzw. 202 des Körpers 20 ausgebildet.

Zwischen der Kathode 21 und der Anode 22 weist der Körper 20 einen als kathodenseitigen Emitter des Hilfsthyristors 2 dienenden Bereich 210 aus n-dotiertem Halbleitermaterial auf, der im Bereich der Kathode 21 an den Oberflächenbereich 201 des Körpers 20 grenzt.

An den kathodenseitigen Emitter 210 des Hilfsthyristors 2 grenzt ein als kathodenseitige Basis des Hilfsthyristors 2 dienender Bereich 220 aus p-dotiertem Halbleitermaterial des Körpers 20 und bildet zusammen mit dem kathodenseitigen Emitter 210 einen np-Übergang 212.

An die kathodenseitige Basis 220 grenzt ein als anodenseitige Basis des Hilfsthyristors 2 dienender Bereich 230 aus n⁻dotiertem Halbleitermaterial des Körpers 20 und bildet zusammen mit der kathodenseitigen Basis 220 einen pn-Übergang 223.

An die anodenseitige Basis 230 grenzt ein als anodenseitiger Emitter des Hilfsthyristors 2 dienender Bereich 240 aus p⁺dotiertem Halbleitermaterial des Körpers 20. Der Bereich 240 bildet einerseits zusammen mit der anodenseitigen Basis 220 einen np-Übergang 234 und grenzt andererseits im Bereich der Anode 22 an den Oberflächenabschnitt 202 des Körpers 20 des Hilfsthyristors 2.

Die Ausführungsbeispiele nach den Figuren 1, 2 und 4 weisen eine elektrische Anodenverbindung 5 auf, welche die Anode 22 des Hilfsthyristors 2 und die Anode 12 des Hauptthyristors 1 elektrisch miteinander verbindet und in Form eines Kurzschlusses ausgebildet ist.

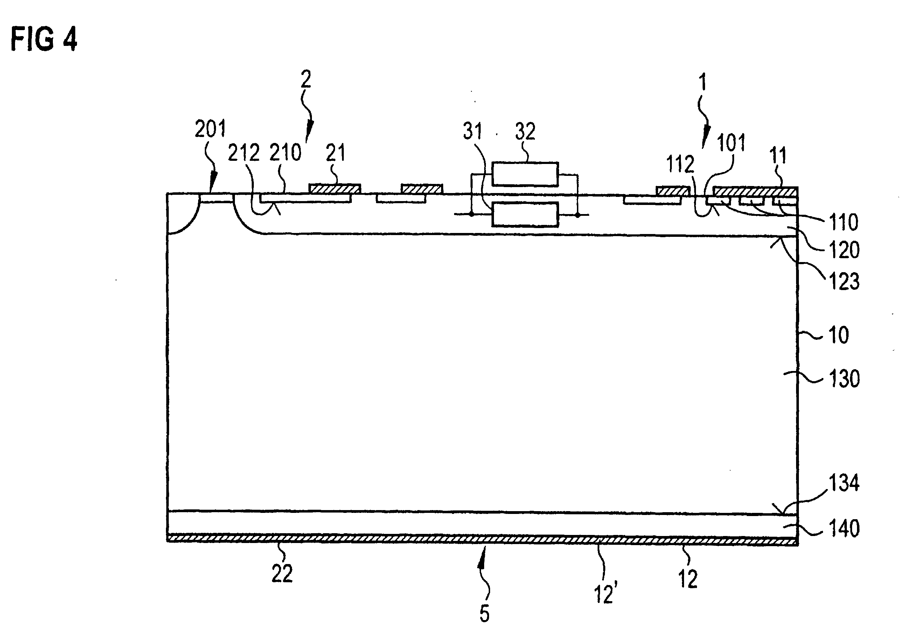

Das Ausführungsbeispiel nach Figur 4 unterscheidet sich von den Ausführungsbeispielen nach den Figuren 1 bis 3 unter anderem dadurch, daß der Hauptthyristor 1 mit seiner Kathode 11 und Anode 12, der Hilfsthyristor 2 mit seiner Kathode 21 und Anode 22 auf einem gemeinsamen Körper aus Halbleitermaterial, beispielsweise dem Körper 10 des Hauptthyristors 1, integriert sind.

Die Kathode 21 des Hilfsthyristors 2 ist wie die Kathode 11 des Hauptthyristors 1 aber von dieser durch einen Zwischenraum 111 getrennt auf dem Oberflächenbereich 101 des Körpers 10 ausgebildet, und die Anode 22 des Hilfsthyristors 2 ist wie die Anode 12 des Hauptthyristors 1 auf dem Oberflächenbereich 102 des Körpers 10 ausgebildet. Der kathodenseitige Emitter des Hilfsthyristors 2 ist durch einen Bereich 210 aus n-dotiertem Halbleitermaterial des Körpers 10 gebildet.

Dieser Bereich 210 ist in dem als kathodenseitige Basis dienenden Bereich 120 aus p-dotiertem Halbleitermaterial des Körpers 10 angeordnet, bildet zusammen mit dem Bereich 120 einen np-Übergang 212 und grenzt im Bereich der Kathode 21 des Hilfsthyristors 2 an den Oberflächenbereich 101 des Körpers 10.

Ansonsten ist bei diesem Ausführungsbeispiel der Körper 10 aus unterschiedlich dotiertem Halbleitermaterial sowohl im Bereich des Hilfsthyristors 2 als auch im Bereich des Hauptthyristors 1 gleich und so wie bei den Ausführungsbeispielen nach den Figuren 1 bis 3 ausgebildet.

Die Anode 22 des Hilfsthyristors 2, die Anode 12 des Hauptthyristors 1 und die Anodenverbindung 5 in Form des Kurzschlusses sind beim Ausführungsbeispiel nach Figur 4 durch eine einzige Elektrode 12' realisiert, die auf dem Oberflächenabschnitt 102 des Körpers 10 ausgebildet ist.

Bei allen Ausführungsbeispielen ist eine Widerstandseinrichtung 3 vorhanden, welche die Kathode 21 des Hilfsthyristors 2 und die Kathode 11 des Hauptthyristors lelektrisch miteinander verbindet und einen von null verschiedenen ohmschen Widerstand definiert.

Erfindungsgemäß ist diese Widerstandseinrichtung 3 so ausgebildet, daß sie einen zeitabhängigen ohmschen Widerstand derart definiert, daß dieser Widerstand während einer Einschaltphase des Hauptthyristors 1 einen relativ großen Wert und während einer Stromführungsphase des Hauptthyristors 1 einen relativ kleinen Wert aufweist.

Überdies ist bei allen Ausführungsbeispielen ist eine Widerstandseinrichtung 3 so ausgebildet, daß der Widerstand von selbst vom relativ großen Wert auf den relativ kleinen Wert absinkt, was mit Hilfe einer Kombination aus einem ohmschen Widerstand eines im wesentlichen festen Wertes und einer Induktivität und/oder Kapazität erreicht wird.

Beim Ausführungsbeispiel nach Figur 1 weist die Widerstandseinrichtung 3 eine Serienschaltung aus dem mit 31 bezeichneten ohmschen Widerstand des im wesentlichen festen Wertes und der mit 32 bezeichneten Induktivität und/oder Kapazität auf.

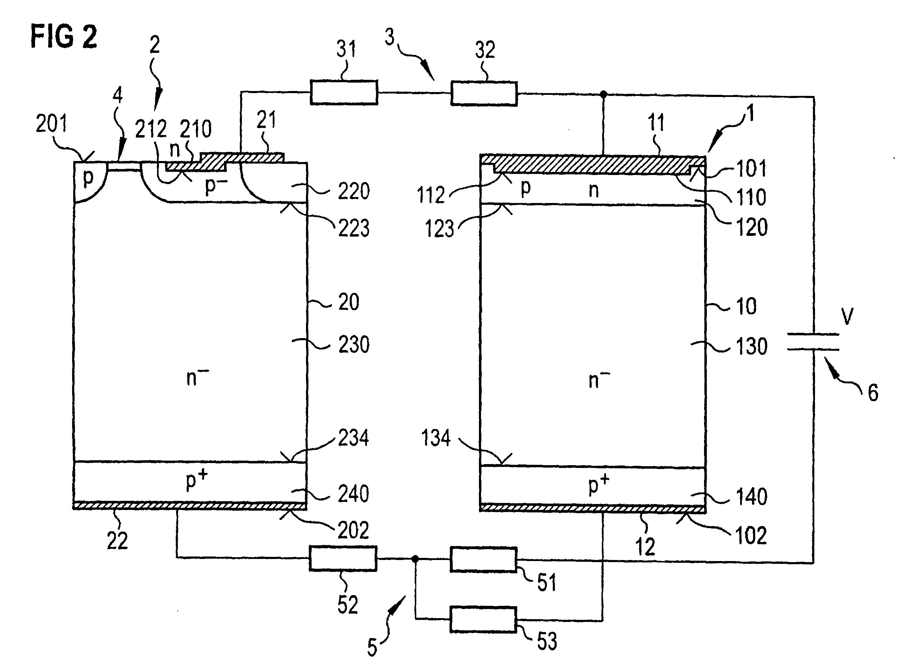

Das Ausführungsbeispiel nach Figur 2 ist eine Variante des Beispiels nach Figur 1 und unterscheidet sich vom Beispiel nach Figur 1 allein durch die besondere Ausbildung der Anodenverbindung 5, die eine Serienschaltung aus einer mit 52 bezeichneten Induktivität und/oder Kapazität und einer Parallelschaltung aus einem mit 51 bezeichneten ohmschen Widerstand und einer mit 53 bezeichneten weiteren Induktivität und/oder Kapazität aufweist.

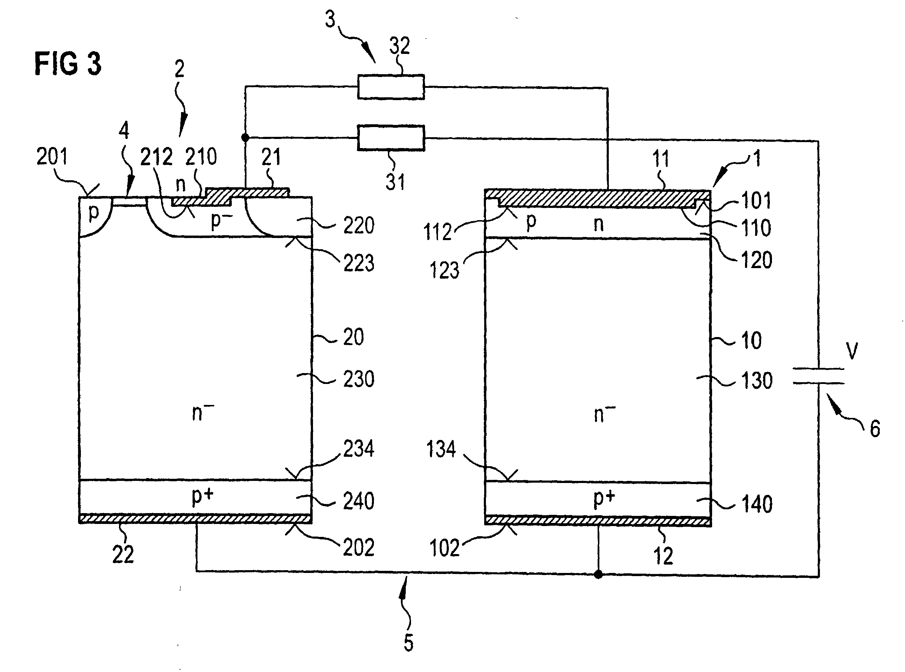

Beim Ausführungsbeispiel nach Figur 3 weist die Widerstandseinrichtung 3 eine Parallelschaltung aus dem mit 31 bezeichneten ohmschen Widerstand des im wesentlichen festen Wertes und der mit 32 bezeichneten Induktivität und/oder Kapazität auf.

Auch beim Ausführungsbeispiel nach Figur 4 weist die Widerstandseinrichtung 3 eine Parallelschaltung aus dem mit 31 bezeichneten ohmschen Widerstand des im wesentlichen festen Wertes und der mit 32 bezeichneten Induktivität und/oder Kapazität auf. Bei diesem Beispiel ist die Widerstandseinrichtung 3 auf dem gemeinsamen Körper 10 aus Halbleitermaterial integriert, beispielsweise im Zwischenraum 111 am Oberflächenbereich 101 des Körpers 10.

Anstelle der dargestellten beispielhaften Kombinationen aus ohmschem Widerstand 31 und Induktivität und/oder Kapazität 32 können auch andere Kombinationen verwendet werden. Das gleiche gilt für die Anodenverbindung 5 des Beispiels nach Figur 2.

In den Figuren 1 bis 3 bezeichnet 6 eine Einrichtung zur Erzeugung einer elektrischen Spannung V zwischen der Kathode 11 und der Anode 12 des Hauptthyristors 1.

Bei speziellen Ausbildungen der Ausführungsbeispiele nach den Figuren 1 bis 4 weist die Widerstandseinrichtung 3 eine Kombination aus dem ohmschen Widerstand 31 und nur einer Induktivität 32 ohne eine Kapazität auf.

Insbesondere bei diesen Ausbildungen ist von entscheidender Bedeutung, daß die Induktivität 32, 52 oder 53 groß genug demissioniert ist, so daß der Stromanstieg zu Beginn des Einschaltphase des Hauptthyristors 1 wirkungsvoll gebremst wird. Während der Widerstandswert des Widerstandes 31 oder 51 im Bereich von 10 Ω bis 200 Ω liegt, müßte der Wert der Induktivität 32, 52 oder 53 im Bereich von 10 µH bis einige mH liegen. Es konnte bei einer seriellen Induktivität 32 ohne parallelem Widerstand gezeigt werden, bei einem Wert von 100 µH oder 1mH der seriellen Induktivität 32 die Temperaturerhöhung des Hilfsthyristors 2 deutlich niedriger ist als ohne Induktivität (Induktivitätswert = 0). Daraus kann geschlossen werden, daß eine Induktivität in der Größenordnung von 1 mH den Hilfsthyristor 2 wirkungsvoll schützt. Sowohl in im Widerstand 32 als auch in der Induktivität 32 wird nur sehr kurzzeitig Leistung verbraucht, so daß eine daraus folgende Erwärmung leicht zu beherrschen ist.

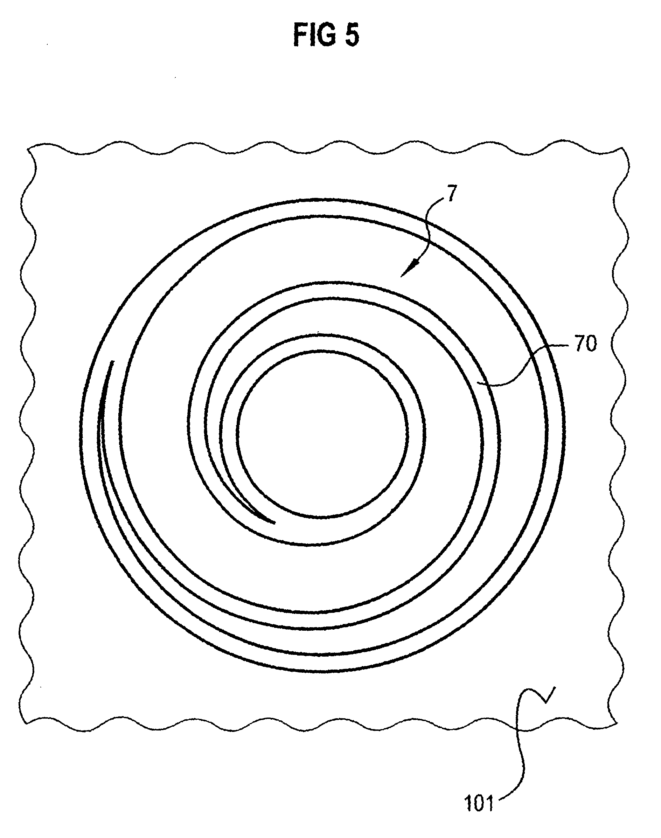

Um eine Induktivität direkt auf einem Körper aus Halbleitermaterial zu integrieren, kann sie in Form einer auf dem Körper aus Halbleitermaterial ausgebildeten Spirale aus elektrisch leitendem Material aufgebracht werden. In der Figur 5 ist eine solche Spirale in Draufsicht beispielhaft dargestellt und mit 7 bezeichnet. Sie besteht aus einem beispielsweise auf dem Oberflächenbereich 101 des Körpers 10 aus Halbleitermaterial ausgebildeten spiralförmig gewundenen Streifen 70 aus elektrisch leitendem Material. Beispielsweise kann eine solche Spirale 7 über einen integrierten Widerstand gelegt werden.

Die Zündeinrichtung 4 zu einer Überkopfzündung des Hauptthyristors 1 über den Hilfsthyristor 2 und die Widerstandseinrichtung 3 ist vorzugsweise eine optische Zündeinrichtung ist, die auf dem Körper 20 oder 10 aus Halbleitermaterial des Hilfsthyristors 2 integriert ist. Die aus dem oben erwähnten Dokument Proceedings of PCIM hervorgehende optische Zündeinrichtung ist dafür geeignet.

Beim Ausführungsbeispiel nach Figur 4 kann die Widerstandseinrichtung 3, die Anodenverbindung 5 und die optische Zündeinrichtung 4 auf gemeinsam auf dem Körper 10aus Halbleitermaterial integriert sein.

## Patentansprüche

1. Thyristoranordnung mit
- einem Hauptthyristor (1), der eine Kathode (11) und eine Anode (12) aufweist,
- mindestens einem Hilfsthyristor (2), der eine Kathode (21) und eine Anode (22) aufweist,
- einer Widerstandseinrichtung (3), welche die Kathode (21) des Hilfsthyristors (2) und die Kathode (11) des Hauptthyristors (1) elektrisch miteinander verbindet und einen von null verschiedenen ohmschen Widerstand definiert,
- einer Anodenverbindung (5), welche die Anode (21) des Hilfsthyristors (2) und die Anode (12) des Hauptthyristors (1) elektrisch miteinander verbindet, und
- einer Zündeinrichtung (4) zu einer Überkopfzündung des Hauptthyristors (1) über den Hilfsthyristor (2) und die Widerstandseinrichtung (3),
**dadurch gekennzeichnet, daß**
- die Widerstandseinrichtung (3) einen zeitabhängigen ohmschen Widerstand derart definiert, daß dieser Widerstand während einer Einschaltphase des Hauptthyristors (1) einen relativ großen Wert und während einer Stromführungsphase des Hauptthyristors (1) einen relativ kleinen Wert aufweist.

2. Thyristoranordnung nach Anspruch 1, **dadurch gekennzeichnet, daß** der Widerstand von selbst vom relativ großen Wert auf den relativ kleinen Wert absinkt.

3. Thyristoranordnung nach Anspruch 2, **dadurch gekennzeichnet, daß** die Widerstandseinrichtung (3) einen ohmschen Widerstand (31) eines im wesentlichen festen Wertes und eine Induktivität und/oder eine Kapazität (32) aufweist.

4. Thyristoranordnung nach Anspruch 3, **dadurch gekennzeichnet, daß** die Widerstandseinrichtung (3) eine Parallelschaltung aus dem ohmschen Widerstand (31) des im wesentlichen festen Wertes und der Induktivität und/oder Kapazität (32) ist.

5. Thyristoranordnung nach Anspruch 3, **dadurch gekennzeichnet, daß** die Widerstandseinrichtung (3) eine Serienschaltung aus dem ohmschen Widerstand (31) des im wesentlichen festen Wertes und der Induktivität und/oder Kapazität (32) ist.

6. Thyristoranordnung nach Anspruch 4 oder 5, **dadurch gekennzeichnet, daß** die elektrische Anodenverbindung (54) ein Kurzschluß ist.

7. Thyristoranordnung nach Anspruch 5, **dadurch gekennzeichnet, daß** die Anodenverbindung (5) eine Serienschaltung aus einer Induktivität und/oder Kapazität (52) und einer Parallelschaltung aus einem ohmschen Widerstand (51) und einer weiteren Induktivität und/oder Kapazität (53) aufweist.

8. Thyristoranordnung nach einem der vorhergehenden Ansprüche, **dadurch gekennzeichnet, daß** der Hauptthyristor (1) mit seiner Kathode (11) und Anode (12), der Hilfsthyristor (2) mit seiner Kathode (21) und Anode (22), die Widerstandseinrichtung (3), die Anodenverbindung (5) und die Zündeinrichtung (4) auf einem gemeinsamen Körper (10) aus Halbleitermaterial integriert sind.

9. Thyristoranordnung nach Anspruch 8, **dadurch gekennzeichnet, daß** die Widerstandseinrichtung (3) eine integrierte Induktivität in Form einer auf dem Körper (10) aus Halbleitermaterial ausgebildeten Spirale (7) aus elektrisch leitendem Material aufweist.

10. Thyristoranordnung nach einem der Ansprüche 1 bis 7, **dadurch gekennzeichnet, daß** der Hauptthyristor (1) mit seiner Kathode (11) und Anode (12) auf einem Körper (10) aus Halbleitermaterial integriert ist, und daß der Hilfsthyristor (2) seiner Kathode (21) und Anode (22) auf einem anderen Körper (20) aus Halbleitermaterial integriert ist.

11. Thyristoranordnung nach einem der vorhergehenden Ansprüche, insbesondere nach einem der Ansprüche 8 bis 10, **dadurch gekennzeichnet, daß** die Zündeinrichtung (4) eine optische Zündeinrichtung ist, die auf einem Körper (10, 20) aus Halbleitermaterial des Hilfsthyristors (2) integriert ist.

## Claims

1. Thyristor arrangement having
- a main thyristor (1), which has a cathode (11) and an anode (12),
- at least one auxiliary thyristor (2), which has a cathode (21) and an anode (22),
- a resistance device (3), which electrically connects the cathode (21) of the auxiliary thyristor (2) and the cathode (11) of the main thyristor (1) to one another and defines an ohmic resistance that is different from zero,
- an anode connection (5), which electrically connects the anode (21) of the auxiliary thyristor (2) and the anode (12) of the main thyristor (1) to one another, and
- a triggering device (4) for breakover triggering of the main thyristor (1) via the auxiliary thyristor (2) and the resistance device (3),
**characterized in that**
- the resistance device (3) defines a time-dependent ohmic resistance in such a way that this resistance has a relatively large value during a switch-on phase of the main thyristor (1) and a relatively small value during a current-carrying phase of the main thyristor (1).

2. Thyristor arrangement according to Claim 1, **characterized in that** the resistance automatically decreases from the relatively large value to the relatively small value.

3. Thyristor arrangement according to Claim 2, **characterized in that** the resistance device (3) has an ohmic resistance (31) of an essentially fixed value and an inductance and/or capacitance (32).

4. Thyristor arrangement according to Claim 3, **characterized in that** the resistance device (3) is a parallel circuit comprising the ohmic resistance (31) of the essentially fixed value and the inductance and/or capacitance (32).

5. Thyristor arrangement according to Claim 3, **characterized in that** the resistance device (3) is a series circuit comprising the ohmic resistance (31) of the essentially fixed value and the inductance and/or capacitance (32).

6. Thyristor arrangement according to Claim 4 or 5, **characterized in that** the electrical anode connection (54) is a short circuit.

7. Thyristor arrangement according to Claim 5, **characterized in that** the anode connection (5) has a series circuit comprising an inductance and/or capacitance (52) and a parallel circuit comprising an ohmic resistance (51) and a further inductance and/or capacitance (53).

8. Thyristor arrangement according to one of the preceding claims, **characterized in that** the main thyristor (1) with its cathode (11) and anode (12), the auxiliary thyristor (2) with its cathode (51) and anode (22), the resistance device (3), the anode connection (5) and the triggering device (4) are integrated on a common body (10) made of semiconductor material.

9. Thyristor arrangement according to Claim 8, **characterized in that** the resistance device (3) has an integrated inductance in the form of a spiral (7) which is made of electrically conductive material and is formed on the body (10) made of semiconductor material.

10. Thyristor arrangement according to one of Claims 1 to 7, **characterized in that** the main thyristor (1) with its cathode (11) and anode (12) is integrated on one body (10) made of semiconductor material, and **in that** the auxiliary thyristor (2) with its cathode (21) and anode (22) is integrated on another body (20) made of semiconductor material.

11. Thyristor arrangement according to one of the preceding claims, in particular according to one of Claims 8 to 10, **characterized in that** the triggering device (4) is an optical triggering device which is integrated on a body (10, 20) made of semiconductor material of the auxiliary thyristor (2).

## Revendications

1. Ensemble thyristor avec
- un thyristor principal (1) comprenant une cathode (11) et une anode (12),
- au moins un thyristor auxiliaire (2) comprenant une cathode (21) et une anode (22),
- un dispositif de résistance (3) reliant électriquement entre elles la cathode (21) du thyristor auxiliaire (2) et la cathode (11) du thyristor principal (1) et définissant une résistance ohmique différente de zéro,
- une liaison d'anodes (5) reliant électriquement entre elles l'anode (21) du thyristor auxiliaire (2) et l'anode (12) du thyristor principal (1), et
- un dispositif d'amorçage (4) pour un amorçage par avalanche du thyristor principal (1) à travers le thyristor auxiliaire (2) et le dispositif de résistance (3),
**caractérisé en ce que**
- le dispositif de résistance (3) définit une résistance ohmique variable dans le temps de manière à ce que cette résistance présente durant une phase de démarrage du thyristor principal (1) une valeur relativement élevée et durant une phase de conduction de courant du thyristor principal (1) une valeur relativement faible.

2. Ensemble thyristor selon la revendication 1, **caractérisé en ce que** la résistance descend d'elle-même de la valeur relativement élevée à la valeur relativement faible.

3. Ensemble thyristor selon la revendication 2, **caractérisé en ce que** le dispositif de résistance (3) comprend une résistance ohmique (31) d'une valeur sensiblement fixe et une inductance et/ou une capacité (32).

4. Ensemble thyristor selon la revendication 3, **caractérisé en ce que** le dispositif de résistance (3) est un montage en parallèle composé de la résistance ohmique (31) de la valeur sensiblement fixe et de l'inductance et/ou capacité (32).

5. Ensemble thyristor selon la revendication 3, **caractérisé en ce que** le dispositif de résistance (3) est un montage en série composé de la résistance ohmique (31) de la valeur sensiblement fixe et de l'inductance et/ou capacité (32).

6. Ensemble thyristor selon la revendication 4 ou 5, **caractérisé en ce que** la la liaison électrique d'anodes (5) est un court-circuit.

7. Ensemble thyristor selon la revendication 5, **caractérisé en ce que** la liaison d'anodes (5) comprend un montage en série composé d'une inductance et/ou capacité (52) et d'un montage en parallèle composé d'une résistance ohmique (51) et d'une autre inductance et/ou capacité (53).

8. Ensemble thyristor selon l'une des revendications précédentes, **caractérisé en ce que** le thyristor principal (1) avec sa cathode (11) et anode (12), le thyristor auxiliaire (2) avec sa cathode (21) et anode (22), le dispositif de résistance (3), la liaison d'anodes (5) et le dispositif d'amorçage (4) sont intégrés sur un corps (10) commun en matériau semiconducteur.

9. Ensemble thyristor selon la revendication 8, **caractérisé en ce que** le dispositif de résistance (3) comprend une inductance intégrée sous forme d'une spirale (7) en matériau électroconducteur réalisée sur le corps (10) en matériau semiconducteur.

10. Ensemble thyristor selon l'une des revendications 1 à 7, **caractérisé en ce que** le thyristor principal (1) avec sa cathode (11) et anode (12) est intégré sur un corps (10) en matériau semiconducteur et **en ce que** le thyristor auxiliaire (2) avec sa cathode (21) et anode (22) est intégré sur un autre corps (20) en matériau semiconducteur.

11. Ensemble thyristor selon l'une des revendications précédentes, en particulier selon l'une des revendications 8 à 10, **caractérisé en ce que** le dispositif d'amorçage (4) est un dispositif d'amorçage optique intégré sur un corps (10, 20) en matériau semiconducteur du thyristor auxiliaire (2).
